Europäisches Patentamt

European Patent Office

Office européen des brevets

(19)

(11) **EP 1 089 440 A1**

(12) **EUROPEAN PATENT APPLICATION**

(43) Date of publication:
**04.04.2001 Bulletin 2001/14**

(51) Int Cl.$^7$: **H03M 13/27**

(21) Application number: **99119012.5**

(22) Date of filing: **28.09.1999**

(84) Designated Contracting States:
**AT BE CH CY DE DK ES FI FR GB GR IE IT LI LU MC NL PT SE**
Designated Extension States:
**AL LT LV MK RO SI**

(71) Applicant: **TELEFONAKTIEBOLAGET L M ERICSSON (publ)
126 25 Stockholm (SE)**

(72) Inventors:
• **Sönning, Raimund
  90411 Nürnberg (DE)**
• **Huamann-Bollo, Gian
  90409 Nürnberg (DE)**

(74) Representative: **HOFFMANN - EITLE
Patent- und Rechtsanwälte
Arabellastrasse 4
81925 München (DE)**

(54) **Interleaver and method for interleaving a data bit sequence**

(57)     The interleaving method and the interleaver (IL) of the invention interleave an input data bit sequence (BS) of M data bits by using an interleaving memory IM having a number of memory locations ($IM_{00}$, $IM_{01}$) for storing the M data bits of the input data bit sequence. Each memory location ($IM_{00}$, $IM_{01}$) stores a respective code symbol consisting of a predetermined number N of data bits selected from the input data bit sequence (BS). The usage of the symbol-wise storage of the data bits of the input data bit sequence (BS) allows to increase the interleaving speed and to decrease the memory requirements in the interleaving memory (IM).

# FIG.5

PRINCIPLE OF THE INVENTION (FOR N= 2)

EP 1 089 440 A1

**Description**

**FIELD OF THE INVENTION**

The invention relates to an interleaver and a method for interleaving an input data bit sequence of a predetermined number of data bits by writing individual data bits to an interleaving memory in a first direction and by reading out the data bits from the interleaving memory in a second direction.

The invention also relates to a transmitter of a communication system comprising an encoder, an interleaver and a modulator which perform channel encoding, interleaving and modulation of a predetermined number of data bits of the input data bit sequence. The modulator uses a specific digital modulation scheme requiring that the bits read out from the interleaving memory are provided as sets of data bits, i.e. code symbols. Such a digital modulation scheme can for example be a QPSK modulation or a 4QAM or 16QAM modulation.

**BACKGROUND OF THE INVENTION**

In a transmitter of a communication system using a frame-wise transmission (e.g. a time division multiplexing or a CDMA method) the digital data information of the user channel is transmitted in individual frames. When several user channels are present simultaneously, as is the case normally for example in a mobile radio communcation system, then several user channels each provide digital data information for each user which is to be inserted into the specific frames on the radio link between the transmitter and the receiver. Each data frame may thus comprise data bits of one user channel only or may comprise data bits of several user channels sequentially. Each frame thus contains a data bit sequence of a predetermined number of data bits (e.g. M bits) belonging to one or several user channels.

Before providing the digital data to a modulator it is advantageous to perform an interleaving of the data bit sequence before transmitting individual frames on the radio link. The advantage of the interleaving process is that a burst error occurring for a predetermined time interval in one frame only destroys partial information of the user data of one frame, since the complete user data is distributed over several frames due to the interleaving process. That is, each frame contains only a portion of each user channel's data. Furthermore, even the interleaving of the data within a single frame can of course increase the robustness against "burst errors".

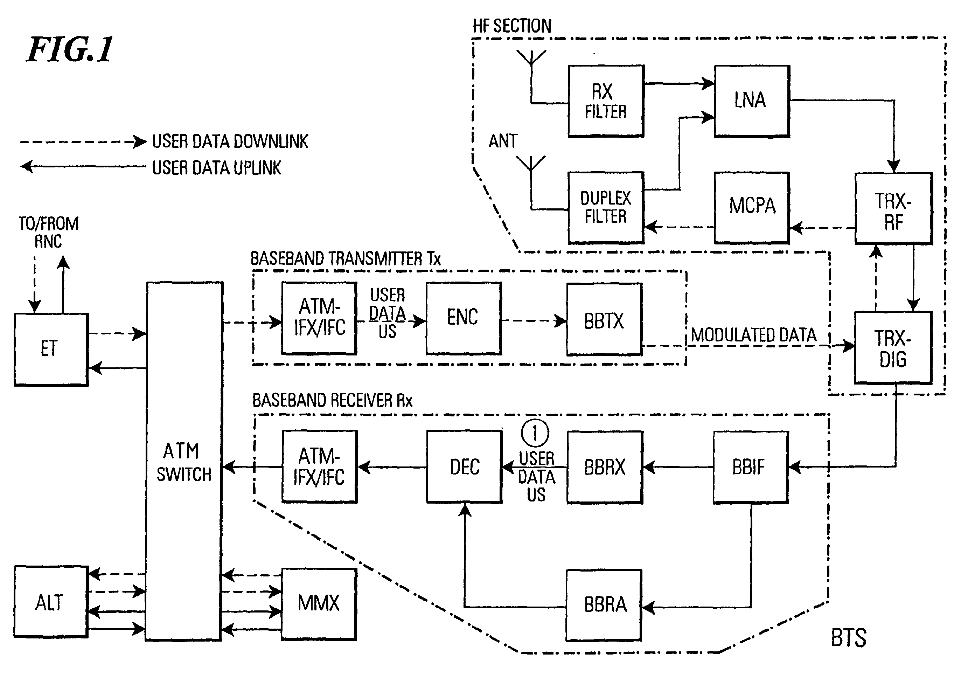

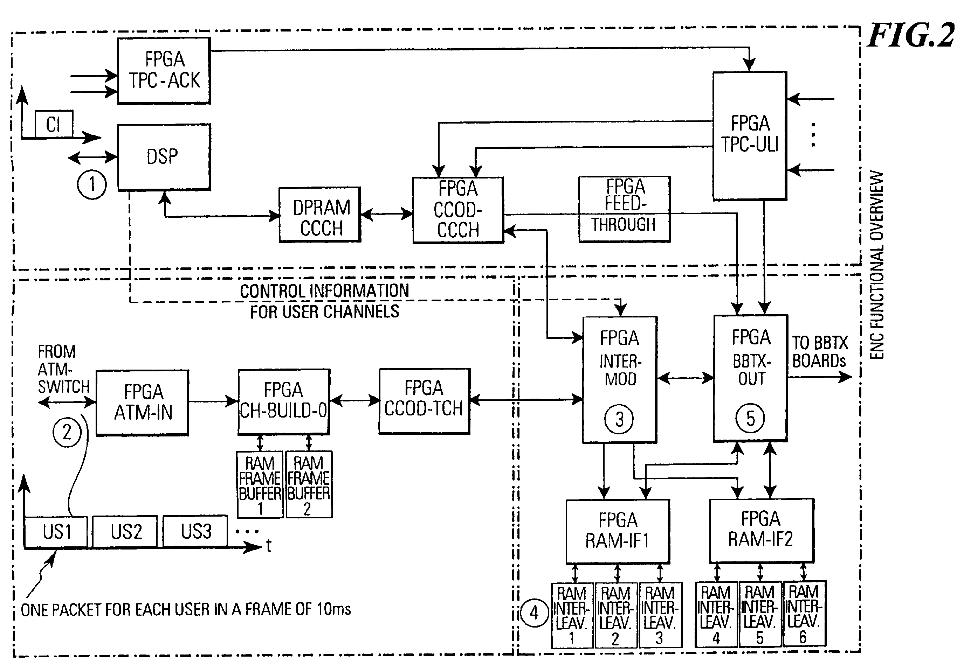

The above described aspects with respect to the interleaving and modulation of user data will be further described with reference to Fig. 1 - 3. Figs. 1, 2 show the basic structure of a CDMA base transceiver station BTS as an example of a transmitter to which the interleaving method and interleaver of the invention can be applied. However, it should be noted that the invention can be applied to any communication system that requires an interleaving and therefore the invention is not restricted to a CDMA communication system.

Briefly summarized, the block diagram in Fig. 1 shows a base transceiver station BTS of a CDMA-system comprising a baseband transmitter TX, a baseband receiver RX and a HF section. In the transmitter TX, user data, for example in the form of ATM packets, is input into a channel encoder unit ENC via an ATM switch and a corresponding interface ATM IFX/IFC. The coded (and also interleaved) data is then modulated and spreaded by a baseband transmitter unit BBTX. The modulated data is then filtered and converted to an analog signal in the unit TRX-DIG, upconverted to the desired carrier frequency in the unit TRX-RF, amplified by a power amplifier unit MCPA and finally transmitted to an antenna ANT via a duplex filter.

In the receiving part of the HF section, two antennas (diversity reception) are commonly used in each sector to receive the signal which is then amplified in the unit LNA, downconverted in the unit TRX-RF, A/D converted and filtered in the unit TRX-DIG. Then the data is demodulated by a RAKE receiver/despreader in the receiver unit BBRX while random access channels (branched off by an intermediate filter unit BBIF) are detected and demodulated in the unit BBRA. The user data US are then decoded in the decoder unit DEC and transmitted to the ATM switch via an ATM interface ATM IFX/IFC.

In the CDMA base transceiver station BTS a bit-interleaving and de-interleaving is respectively performed in the encoder ENC in the baseband transmitter TX and the decoder DEC in the baseband receiver RX.

Fig. 2 shows a functional overview of the encoder ENC, where a plurality of data of individual user channels US1, US2, US3 are input as sequential packets including respective data bit sequences at ②into the ATM interface field programmable gate array FPGA ATM-IN. Upon channel coding in the FPGA CCOD-TCH interleaving is performed in the FPGA INTER-MOD at ③. That is, in Fig. 2 a number $N_{USCH}$ of user channels (e.g. up to 300 different channels) input user data US at ② while control information CI for controlling the transmission of said data bit sequences is input at the digital signal processor DSP ①or generally by the FPGA INTER-MOD ③. The data bits plus their associated control information are interleaved and time-aligned in the FPGA modulator FPGA INTERMOD ③using a memory arrangement of 3 RAMs shown at ④and the interface FPGA RAM-IF1. The interleaved and time-aligned data is then transmitted to the baseband transmitter unit BBTX via the FPGA BBTX-OUT⑤.

Thus, in addition to channel encoding and interleaving the encoder ENC in Fig. 2 combines data symbols from the user channels US1, US2, US3... and control information CI, whereafter the combined information is provided to the baseband transmitter unit BBTX.

Data bits are provided in the form of code symbols representing one element of an alphabet of a digital modulation scheme such as QPSK or 16QAM. The control information associated with every code symbol is used to control other processing parts within the baseband transmitter unit BBTX. In general the BBTX unit spreads each code symbol to the common chip rate and performs a multiplication with the CDMA code and a weighting with a specific transmission power.

Furthermore, in such a transmitter, the data information of the user channel may be transmitted in individual frames. When several user channels are present, as is the case normally for example in a mobile radio communication system, then several user channels each provide digital data information which is to be inserted into the specific frames on the radio link between the transmitter of the base stations and the mobile stations. Each data frame may comprise data packets of several user channels which may arrive sequentially. Each packet is separately encoded and interleaved, before code symbols are formed and provided in parallel for all user channels to the CDMA modulator in the unit BBTX. The parallel processing towards the CDMA modulator is necessary because of the CDMA technique where all channels are added up prior to transmission.

Each packet thus contains a data bit sequence of a predetermined number of data bits (e.g. $M_i$ bits) belonging to one user channel. The individual code symbols formed from the input data bit sequence in each packet may consist of e.g. N = 2 data bits representing the 4 possible states of a QPSK modulation (i.e. an I bit and a Q bit) and the control information CI may consist of e.g. L = 4 control bits indicating specific control functions with respect to the corresponding code symbols.

As described above, in Fig. 2 a plurality of data of individual user channels US1, US2, US3, ... are input as sequential packets comprising respective data bit sequences at ②. An interleaving is then performed in the FPGA INTER-MOD ③ and the memory arrangement ④. In addition, control information CI is input to the DSP ①. Alternatively, the DSP ① or even the FPGA ③ themselves may generate the control information CI. The control information is combined with the data bits, interleaved and time-aligned also in the FPGA ③ together with the memory arrangement of the 3 RAMs shown at ④. The data bits in form of code symbols (representing one state of a digital modulation scheme) together with the associated control information is then transmitted to the baseband transmitter unit BBTX via the FPGA BBTX-OUT ⑤.

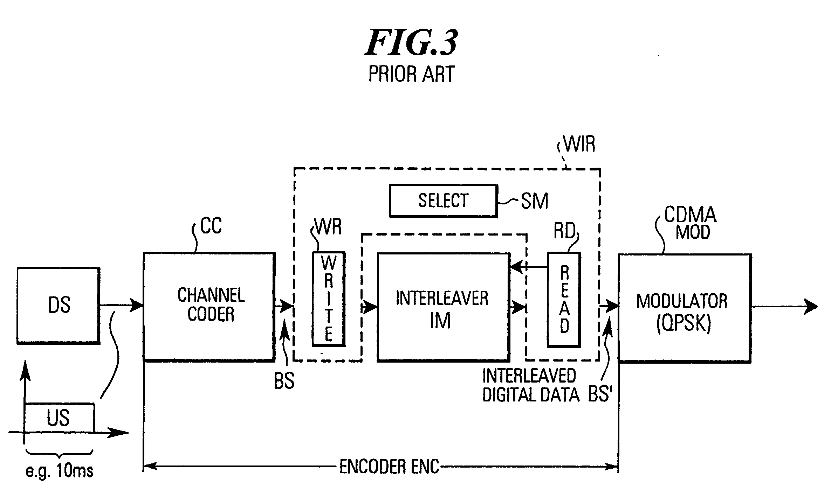

Although Figs. 1, 2 show a special structure of a CDMA transmitter, generally, a digital transmitter using a frame-wise processing of data packets can be summarized as shown in Fig. 3. That is, a data source DS provides digital data US in form of packets to a channel encoder CC. The channel encoder CC may be a convolutional encoder, however, also other codes may be used, e.g. block codes, turbo codes, etc.. If the coder is a convolutional encoder it makes use of a specific rate and constraint length as predefined by the encoder polynomial. For example, the channel encoder ENC in Figs. 1, 2 uses a convolutional coder with a rate r = 1/2 and a constraint length c = 9.

The channel encoded digital data output by the channel encoder CC are again data packets comprising a data bit sequence BS containing $M_i$ data bits.

From the individual data bits of the data bit sequence code symbols each consisting of a number N of data bits are formed depending on the used digital modulation scheme. A write/read means W/R contains a selection means SM for extracting or selecting from the input data bit sequence BS data bits, which respectively belong to each other for forming such code symbols.

The interleaved digital data is output to the digital modulator MOD in the baseband transmitter unit BBTX which performs a modulation of the interleaved bits output by the interleaver IL. For example, if the modulator uses a QPSK modulation, the bits are provided to the modulator as code symbols containing two bits, namely an I-bit and a Q-bit. For example, the CDMA transmitter in Fig. 1 uses a QPSK modulation in the modulator BBTX. However, other digital modulation schemes may be used that require the provision of code symbols consisting of a different number of data bits. For example, a 16QAM method requires code symbols of four bits each, and a 4QAM method requires code symbols of two bits each.

As explained above, in Fig. 3, a write/read means W/R comprises the select means SM which selects corresponding data bits from the input data bit stream BS to form respective code symbols, a write means WR which writes the data bits from the input data bit stream into the interleaving memory in a row direction, and a read means RM which reads the data bits from the interleaving memory in a column direction.

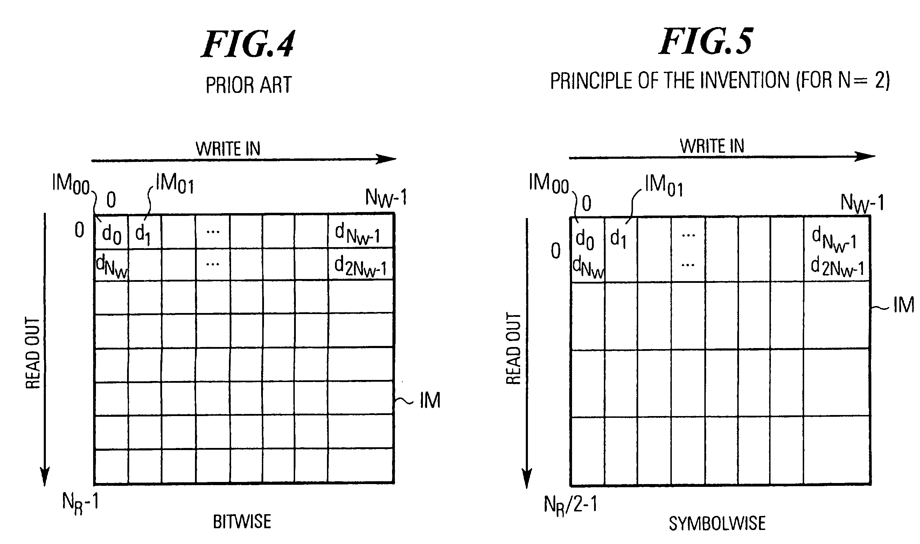

As is seen in Fig. 2, there may be a great plurality of user channels (up to 300) and therefore the amount of data to be processed within each time interval of a frame (e.g. T=10ms) is very large. Therefore, the processing time and/or the memory requirements to perform channel encoding, bit-interleaving and time-alignment (bit-interleaving and time-alignment is as described above performed in the FPGA ③) in Fig. 2 are very large. In addition, all processing has to be performed serially for all channels in a certain time interval (T=10ms), since the data actually arrives in serial data frames at the FPGA ③ in Fig. 2. To keep the memory requirements and processing time small, it is the intention to only use preferrably one hardware resource for interleaving all channels US in the system. Hereinafter, the memory requirements and the time requirements for performing an interleaving is illustrated with reference to Fig. 4.

Typical interleaving of an input data bit sequence BS comprising M data bits $d_0$, $d_1$...$d_{M-1}$ is shown in Fig. 4.

Fig. 4 shows an interleaving matrix IM (i.e. in an interleaving memory) which is written row by row and read column by column for performing the interleaving of the data bits. Assuming that the input data bit sequence BS consists of M data bits, and each data bit is stored in its own memory location, then the interleaving matrix IM must have at least M memory locations $IM_{00}$, $IM_{01}$ etc. in an interleaver memory. The number of columns $N_W$ and the number of rows $N_R$ depend in fact on the interleaving depth which is here expressed as the number of columns before the writing of data bits jumps to the next row. The interleaving depth is always predetermined in the interleaver IL and if the interleaver depth is $N_W$, then the storage of M data bits requires $N_R = \lceil M/N_W \rceil$ rows.

Conventionally, as is shown in Fig. 4, each data bit di of the input data bit sequence BS is stored at one memory location $IM_{nw,nr}$ defined by the respective row and column addresses $n_W = 0,1,2...N_W-1$ and nr = 0, ..., $N_R-1$. As explained above, the interleaving process itself consists of a write and read process to and from the interleaving matrix in Fig. 4. Each of the processes (writing or reading) for all channels must be accomplished within a frame period when processing is performed in a frame-wise manner, but both processes have to be fast enough to be able to handle the great number of data packets of all users in the system within one frame period, even if the number of user channels US is very large.

For example, in Fig. 4, all data bits of one packet are written row by row starting in row 0 and all output bits are read column by column starting in column 0. Assuming the dimension of the bit-interleaving matrices to be $M=N_R*N_W$ (number of rows* number of columns) the interleaving matrices must be filled completely by the data bit sequences contained in one frame in the predermined time period of one frame. Afterwards the procedure is repeated in the next frame starting at rows 0 again. Therefore, in the afore-mentioned time interval of 10ms each matrix has to be accessed (written or read) $N_R*N_W$ times. And as packets arrive sequentially this writing or reading is also done sequentially.

In the conventional method during reading, the read means RM outputs the data bits as code symbols as required by the digital modulation method to the modulator MOD. For example, the read means RM may combine the bits $d_0$ and $d_{N_W}$ after two read cycles by accessing the respective two separate memory locations thereof and then provide the bits as code symbol to the modulator MOD.

It will be appreciated that a considerable amount of time is used to read and write the data if the number of user channels is large since all interleaver matrices are accessed sequentially. The time for accessing the matrices as well as the storage requirements for storing the matrices can therefore be very large when a great plurality of user channels is used or when the input data packets comprise a large number M of data bits. If, e.g., each data packet has M bits and U packets arrive in one frame, the total number of bits is either U*M bits (when each packet has the same length) or

$$\sum_{u=1}^{U} M_u$$

bits (when the packets have different lengths) for u=1...U.

## SUMMARY OF THE INVENTION

As explained above, there is the problem that the reading and writing of the interleaving memory requires a lot of time if the user data is stored as shown in Fig. 4. Since each data bit has assigned to it one individual memory location at a respective row and column intersection, the matrix will have to be accessed (written or read) exactly M times and furthermore there must be exactly M memory locations. It should be noted that in principle M only relates to one channel. That is, if there is only one channel, then M represents the number of bits of one user channel, and if there are $N_{USCH}$ user channels then M represents the sum of all bits of all user channels, i.e. $M=\Sigma M_i$ for i=1....$N_{USCH}$, for 10ms. However, during the process, of course, each channel is separately interleaved, i.e. per channel the memory is only accessed M1, M2,...$M_i$... $M_{N_{USCH}}$ times.

Therefore, it is the object of the present invention to provide an interleaver and an interleaving method, which allow to perform an interleaving in a transmitter with minimum hardware requirements at higher processing speed.

## SOLUTION OF THE OBJECT

This object is solved according to claim 1 by an interleaver for interleaving an input data bit sequence of M data bits, including an interleaving memory having a number of memory locations for storing said M data bits of said input data bit sequence, wherein each memory location stores a respective code symbol consisting of a predetermined number N of data bits selected from said input data bit sequence, wherein the number of data bits N per each code symbol is the same, but each code symbol consists of different data bits respectively selected from the input data bit sequence.

This object is also solved according to claim 11 by an interleaver for a modulator of a transmitter, which uses a predetermined digital modulation scheme where a number N of data bits are modulated as one code symbol, for interleaving an input data bit sequence of M data bits, comprising an interleaving memory having $N_W \times N_R/N$ memory locations for storing said M data bits of said input data bit sequence, where $N_W$ denotes the number of columns corresponding to the interleaving depth and $N_R/N$ denotes the number of rows in said interleaving memory, a write/read means for writing said M data bits into said memory locations in the row direction such that each memory location stores simultaneously a number N of data bits forming one code symbol according to the predetermined modulation scheme; and for reading out said code symbols from said memory locations in the column direction to provide an interleaved output data bit sequence of said stored code symbols, wherein each code symbol is formed by N respective data bits respectively selected from the $[m=n_W+(n-1)*N_W+n_R*N_W*N]$-th positions of the input data bit sequence, where n = 1, 2...N denotes the n-th data bit of the code symbol, $n_W = 0, 1,...N_W-1$ denotes the column address of the memory location of the code symbol and $n_R = 0, 1,...(N_R/N)-1$ denotes the row address of the memory location of the code symbol.

This object is also solved according to claim 17 by a method for interleaving an input data bit sequence of M data bits using an interleaving memory having a number of memory locations for storing said M data bits, comprising the steps of selecting from said input data bit sequence simultaneously a predetermined number of data bits to form a respective code symbol, writing the data bits of a respective code symbol to a respective memory location in said interleaving memory, wherein the number of data bits per each code symbol is the same, but each code symbol consists of different data bits respectively selected from the input data bit sequence.

This object is also solved according to claim 27 by a method for interleaving an input data bit sequence of M data bits to output an interleaved output data bit sequence to a modulator of a transmitter, which uses a predetermined digital modulation scheme where a number N of data bits are modulated as one code symbol, using an interleaving memory having $N_W \times N_R/N$ memory locations for storing said M data bits, where $N_W$ denotes the number of columns corresponding to the interleaving depth and $N_R/N$ denotes the number of rows in said interleaving memory, comprising the steps of selecting from said input data bit sequence a predetermined number (N) of data bits to form a respective code symbol, writing said M data bits into said memory locations in the row direction such that each memory location stores simultaneously said selected number N of data bits forming one code symbol according to the predetermined modulation scheme, reading out said code symbols from said memory locations in the column direction to provide an interleaved output data bit sequence of said stored code symbols, wherein each code symbol is formed by selecting N respective data bits respectively from the $[m=n_W+(n-1)*N_W+n_R*N_W*N]$-th positions of the input data bit sequence, where n = 1, 2...N denotes the n-th data bit of the code symbol, $n_W = 0, 1,...N_W-1$ denotes the column address of the memory location of the code symbol and $n_R = 0, 1,...(N_R/N)-1$ denotes the row address of the memory location of the code symbol.

A transmitter comprising an encoder and a modulator comprising such an interleaver of the invention also solves the above object.

The basic idea of the invention is to leave the conventional approach of a bit-wise storage of data bits at each memory location. According to the invention each memory location stores a respective code symbol consisting of a predetermined number of data bits selected from the input data bit sequence. The predetermined number of data bits forming each code symbol is determined by the modulation technique used in the modulator. If for example a QPSK modulation is used, then the code symbol consists of two bits, namely an I bit and a Q bit. Of course, the number of data bits per code symbol is the same for each code symbol read out from the interleaving matrix, however, each code symbol consists of different data bits respectively selected from the input data bit sequence.

According to the invention an intrinsic property of the memory itself is used, namely that one memory location can of course store more than one bit, e.g. depending on the memory depth of 4bit, 8bit, 16bit or 32bit etc. Storing each code symbol required by the modulator at a particular memory location drastically reduces the access time, since for reading out N bits (corresponding to one code symbol) the interleaving memory only has to be accessed once. At the same time, the size of the interleaving memory can be reduced, since several bits are stored at each memory location. Thus, the symbol-wise storage of data bits of the input data bit sequence drastically reduces the memory requirements and increases the processing speed, i.e. the interleaving speed. The advantage is, that the modulator can be easily provided with the code symbols it requires at a higher speed.

Thus, in the modulation scheme two function blocks cooperate, namely the interleaving and the digital modulation. Preferably, for a QPSK modulation scheme the interleaving and the QPSK modulation (the separation of bits in I and Q parts) is combined into one process and the bits are not stored bit-wise in the interleaving matrix any longer as in Fig. 4, but in fact the bits are stored symbol-wise. However, any other modulation scheme where the bitstream is divided into code symbols consisting of a plurality of N data bits can advantageously use the symbol-wise storage.

Thus, the symbol-wise storage reduces the memory, increases the processing time and is thus optimally adapted to the subsequent digital modulation performed in the modulator.

Using the "symbol-wise" storage, it is clear that the reading and writing of the interleaving matrix is faster, since the matrix only has to be accessed $N_W*N_R/N$ times ($N_W$: number of columns, $N_R$: number of rows) instead of $N_W*N_R$ times. Preferably, if N=2, the interleaver has a write/read means comprising two shift register banks each consisting of a first and second shift register for performing the symbol-wise storage of the data bits at the memory locations when an input data bit sequence is received. A first register always stores the even bits and a second register always stores the odd bits and a select/write means is provided for alternately reading two bits from the first register or from the second register. After each reading a shifting of the respective register is performed. Thus, after a preload time where the shift register of length $N_W$ is first filled with data bits, the storage of code symbols in the interleaving matrix can be performed in a fast and reliable manner.

Further advantageous embodiments of the invention relate to the reduction of the preload time that is necessary for loading shift register before interleaving the data bits. Other advantageous embodiments and improvements of the invention can be taken from the dependent claims. Hereinafter, the invention will be explained with reference to its embodiments as described in the following description and shown in the attached drawings.

**BRIEF DESCRIPTION OF THE DRAWINGS**

In the drawings:

Fig. 1        shows an overview of a CDMA base transceiver station BTS to which the invention can be applied;

Fig. 2        shows the encoder block of the encoder ENC shown in Fig. 1, in particular an interleaver ③ realized as a FPGA & RAM ④;

Fig. 3        shows a principle block diagram of a digital transmitter according to the prior art, showing as summary diagram an interleaver IL arranged between a channel coder CC and a digital modulator MOD;

Fig. 4        shows the interleaving process in an interleaving matrix IM with a bit-wise storage of data bits do, $d_1$, $d_2$.. $d_{2N_W-1}$ according to the prior art;

Fig. 5        shows the interleaving process according to the invention using a symbol-wise storage of data bits in the interleaving matrix IM for an example of a QPSK modulation;

Fig. 6a       shows entries in the interleaving memory IM according to the invention for the case N=2 (QPSK modulation) and an interleaving depth of $N_W$=4 where the numbers in the interleaving matrix IM denote the bit position of the bits in the input data bit sequence;

Fig. 6b       shows the entries of an interleaving matrix for N=4 (16QAM) and $N_W$=4 similar as in Fig. 6a;

Fig. 6c       shows the entries of an interleaving matrix for N=2 and an odd $N_W$=7;

Fig. 7        shows an embodiment of the invention using a write/read means W/R for performing the symbol-wise writing/reading to/from the interleaving matrix IM;

Fig. 8a       shows an embodiment of the shift register SHR shown in Fig. 7 including two register banks b0, b1 for the case of N=2 (QPSK modulation) and even $N_W$, also showing an embodiment of the selection means as a switch means SW1, SW2; and

Fig. 8b       shows an embodiment of the shift register SHR shown in Fig. 7 including two register banks b0, b1 for the case of N=2 and an odd $N_W$ (here $N_W$=7); and

Fig. 9        shows a flow chart of an embodiment of the interleaving method of the invention using the register banks as shown in Fig. 8a.

In the drawings, the same or similar reference numerals denote the same or similar parts or steps everywhere. Hereinafter, first the interleaving principle of the invention will be explained generally with reference to Fig. 5. It should be understood that the invention is neither restricted to the CDMA system shown in Fig. 1, 2, nor is the invention limited to the case of a particular digital modulation scheme such as QPSK, 16QAM. In principle, the invention is neither restricted to a frame-wise provision of the input data bit sequence nor do the individual successive frames have to have the same length, since an interleaving can be carried out according to any length of the input data bit sequence. Also the interleaving depth need not necessarily be an even number. Thus, any combination of the number M of data bits, the number of columns of $N_W$ and the number of rows $N_R$ and N can be employed, if it is only guaranteed, that the interleaving matrix will store the data with a number N of data bits in each memory location, as will be explained below.

## PRINCIPLE OF THE INVENTION

Fig. 5 shows the interleaver matrix having a number of locations $IM_{00}$, $IM_{01}$,... for storing M data bits of an input data bit sequence BS. As shown in Fig. 5, each location stores a respective code symbol comprising a predetermined number N of data bits selected from the input data bit sequence BS. Whilst Fig. 5 shows an example of N=2, i. e. each code symbol consists e.g. of two bits I and Q for a QPSK modulation representation, the principle shown in Fig. 5 is generally applicable to any integer value of N. According to the invention, an intrinsic property of performing the interleaving in a interleaving memory is that each memory location can not only store one single individual bit, but a plurality of bits for example 4, 8, 16 or even 32 bit for each memory location.

Assuming that the code symbol stored in each memory location consists of N bits, then the size of the interleaving matrix can be reduced to $N_W*N_R/N$ memory locations, whilst the interleaving matrix can still store the M data bits of the input data bit sequence, because each memory location stores a plurality of bits corresponding to the respectively required code symbol. $N_W$ denotes the number of columns corresponding to the interleaving depth and thus for storing M data bits using a predetermined interleaving depth, the interleaving matrix only comprises $N_R/N$ rows. Since in Fig. 5 the numbering in the column and row direction starts at 0, the highest column address is $N_W-1$ and the highest row address is $N_R/N-1$. Thus, selecting from the input data bit sequence of M bits respectively a number of N data bits to be stored commonly in one memory location, the access time and the needed memory space inside IM of the interleaving matrix IM can be reduced.

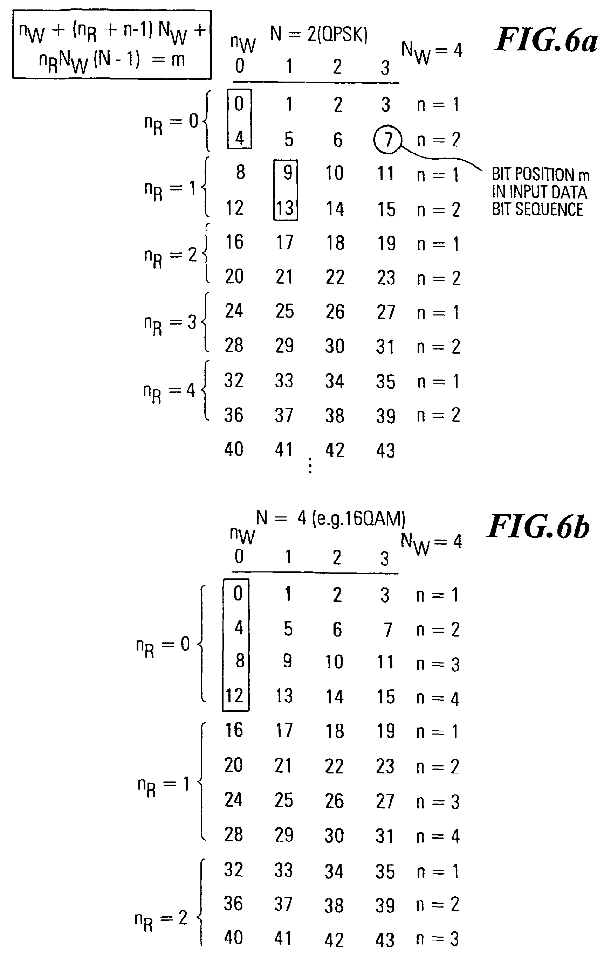

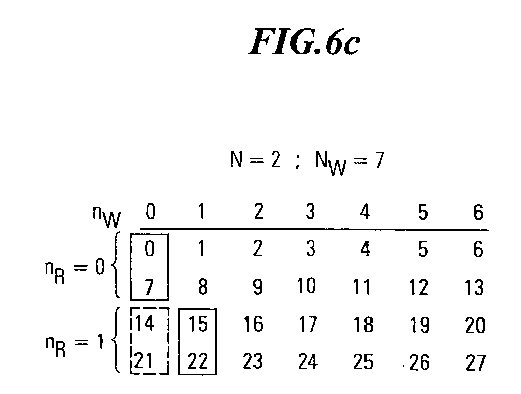

Of course, assuming that the same data bits as in Fig. 4 will again form the code symbol (e.g. for N=2 the combination of $d_0$, $\mathbf{d}_{N_W}$) it is assumed that during the writing process in the row direction the respective data bits of the input data bit sequence are already present as the required set of data bits forming the corresponding code symbols. This selection of the data bits from the input data bit sequence by the selection means SM will be explained below with reference to Fig. 6a, 6b, 6c.

Since the CDMA base transceiver station BTS schematically illustrated in Fig. 1, Fig. 2 uses a QPSK modulation (i.e. N=2) the symbol-wise storage as shown in Fig. 5 can advantageously be applied to this transmitter. That is, the user data is not stored bit-wise but symbol-wise (I and Q data bits) in the interleaving matrix, since the modulator MOD requests the provision of code symbols consisting of two bits I and Q. Thus, the symbols $d_0$ & $d_{N_W}$,..., $d_{N_W-1}$ & $d_{2N_W-1}$ are stored in the first row 0 in the interleaving matrix. It automatically follows that the number of rows required is only $N_R/N = N_R/2$ whilst the number of columns remains $N_W$ (i.e. the interleaving depth is the same as in Fig. 4). Storing the symbols as indicated in Fig. 5 decreases at least the read time from the interleaving matrix. That is, for the read process the matrix only has to be accessed $N_W*N_R/2$ times now, i.e. exactly half the number of accesses than in the conventional single-bit interleaving scheme (Fig. 4).

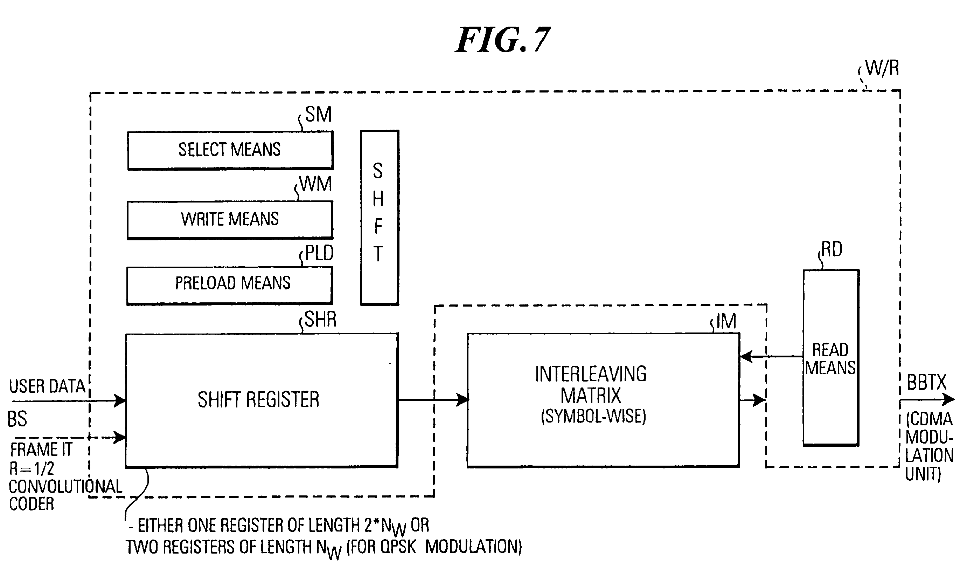

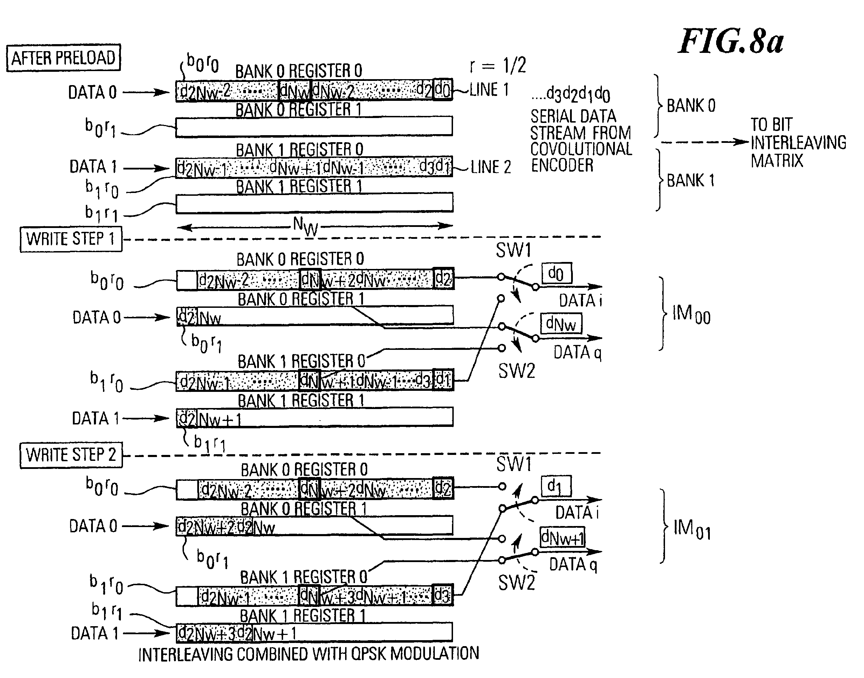

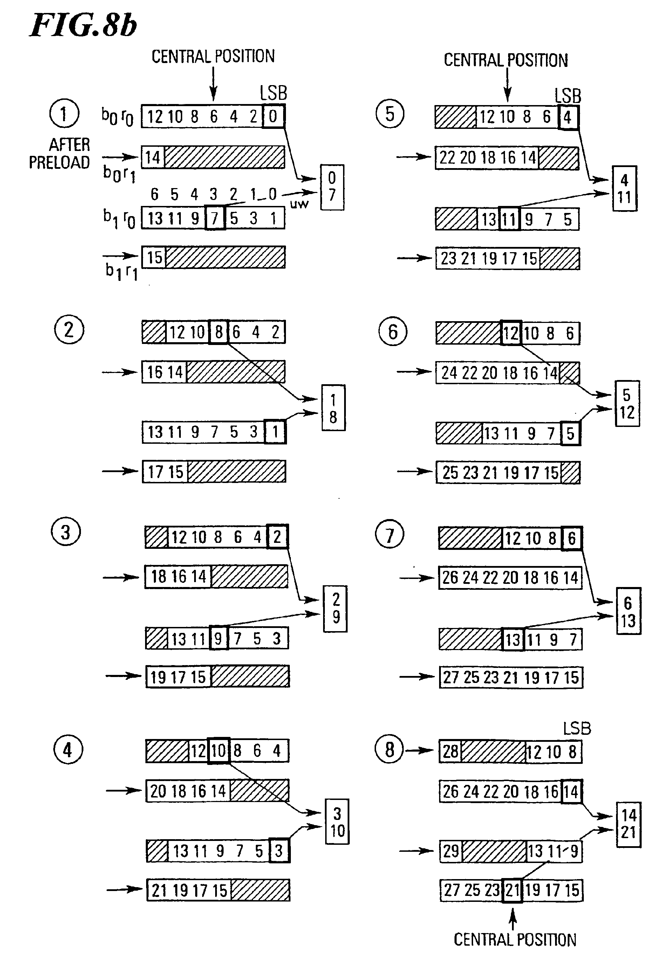

In the write process, bits will be written to the matrix also only $N_W*N_R/2$ times. However, this presupposes that the code symbols, e.g. $d_0$, $\mathbf{d}_{N_W}$ are already available as a data bit pair selected from the input data bit sequence by the select means. Since the data arrives serially from the convolutional encoder, the select means SM is provided to select the appropriate bits from the serially arriving input data bit sequence. According to one embodiment of the invention shown in Fig. 7, 8, this can advantageously be carried out by using a plurality of registers as explained below.

However, before coming to a specific discussion of the embodiment of the selection and storage process for forming code symbols representing the QPSK modulation (N=2), Fig. 6 is used to generally describe which data bits need to be combined (selected) for each code symbol (depending on an arbitrarily selected interleaving depth $N_W$ and code symbol length N).

As was explained above, generally a read/write means (see W/R in Fig. 3 or Fig. 7) is provided for writing the M data bits into the memory locations such that each memory location stores the number N of selected data bits forming one code symbol and for reading out said code symbols from said memory locations to provide the interleaved output data bit sequence of the stored code symbols to the modulator MOD. Interleaving is achieved by different address generation for write and read process. Essentially, the modulation scheme determines how many data bits and which data bits need to be combined from the input data bit sequence.

For explaining the selection of data bits from the input data bit sequence BS by the select means SM the following assumptions are made. The bit positions in the input data bit sequence are numbered m=0,1,2...M-1, i.e. the first arriving data bit has the index m=0. The interleaving depth (i.e. the number of columns) is $N_W$ and the first column index is denoted $n_W=0$. Likewise, the number of rows necessary in order to store the M data bits is $N_R/N$ and the first row index is denoted $n_R=0$ (see Fig. 6). N denotes the number of data bits per code symbol and n=1 denotes the first data bit, n=2 denotes the second data bit...n=N denotes the N-th bit of the code symbol.

Fig. 6a shows the example for N=2 (i.e. QPSK modulation) and Fig. 6b shows the example for N=4 (i.e. 16QAM). The numbers in the matrices in Fig. 6a, 6b denote the bit position m of the input data bit sequence having M data bits.

In Fig. 6a an equation is stated that indicates the bit positon m of the data bits that need to be combined for each code symbol and memory position. That is, the bit position m in the input data bit sequence is expressed as:

$$m=n_W+ (n-1)^*N_W+n_R{}^*N_W{}^*N \qquad (1)$$

That is, each code symbol is formed by N respective data bits respectively selected from the m-th positions (as indicated with the above equation) of the input data bit sequence, where n=1,2...N denotes the n-th data bit of the code symbol, $n_W=0,1...N_W-1$ denotes the column address of the memory location of the code symbol and $n_R=0,1...(N_R/N-1)$ denotes the row address of the memory location of the respective code symbol.

This should be illustrated with an example in Fig. 6a (see the framed code symbols). For example, if the memory location $IM_{00}$ of the location $n_R=0$, $n_W=0$ in the top left corner is to be specified, then $n_W$, $n_R$, $N_W$ and N is entered in the above equation (1) and m(n=1)=0 and m(n=2)=4 indicate that the 1-st and the 5-th bit of the input data bit sequence is selected to form the code symbol $IM_{00}=d_0,d_4$ (or $d_4,d_0$, depending on the location of the most significant bit).

The code symbol $IM_{11}=d_9,d_{13}$ is formed by the 10-th and the 14-th bit of the input data bit sequence. This is carried out for all two-bit code symbols in Fig. 6a. Likewise, in Fig. 6b four data bits form one code symbol whilst still the above equation (1) can be used for determining the bit positions to be written to the respective memory location.

The above equation (1) also holds generally for an arbitrary interleaving depth $N_W$ in the column direction. Thus, effectively the same code symbols as would be supplied by an IL line in Fig. 4 are also supplied by an IL line in Fig. 5 using the general expression in equation (1), but the memory locations now each store a code symbol to be provided to the modulator MOD. This generally reduces the access time and the memory requirements.

The selection of the data bits according to the above given equation (1) is general and independent of the special combination of $N_W$, N and M. However, the main advantage is that the input data bit sequence having a length of $M=N_W{}^*N_R$ bits can be written and read from the interleaving memory as code symbols in only $N_W{}^*N_R/N$ write/read cycles.

As explained above, a method of the invention for interleaving an input data bit sequence of M data bits using an interleaving memory having a number of memory locations for storing the M data bits comprises a simultaneous selection of a predetermined number N of data bits from the input data bit sequence to form a respective code symbol (as illustrated with the above equation (1) and with reference to Fig. 6). Then, data bits of the respective code symbol are written to one respective memory location in the interleaving memory and the number of data bits per each code symbol is the same but due to the selection process each code symbol consists of different data bits respectively selected from the input data bit sequence.

As can be seen from the above description, the interleaving scheme is also independent of the convolutional encoder, however, the input data bit sequence BS of M data bits can preferrably consist of data bit sets each including a predetermined number 1/r of bits resulting from a convolutional encoding of a respective data bit using a predetermined coding rate, e.g. r=1/2, in a convolutional encoder CC shown in Fig. 3. However, the only information needed by the write/read means W/R is how long the input data bit sequence is (e.g. M) before a writing in of the interleaving matrix should be performed. Whether or not the actual data bits of the bit sequence relate to encoded or uncoded bits is of no relevance for the interleaving process itself, but in the case of convolutionally encoded bits, these bits can arrive parallely and thus the writing time, more specifically a preload time, can be reduced during the selection process as explained below with further details.

## FIRST EMBODIMENT OF THE WRITE/READ MEANS

Fig. 7 shows an embodiment of the write/read means W/R used for writing in the data bits of the input bit sequence BS as code symbols to the interleaving matrix in the row direction and for reading out the code symbols sequentially in the column direction to provide interleaved data bits to a modulation unit MOD generally shown in Fig. 3.

As shown in Fig. 7, the write/read means W/R comprises a shift register means SHR, a select means SM, a write means WM, a read means RD, a preload means PLD and a shift means SHFT. User data, i.e. the input data bit sequence BS, is input to the shift register means SHR.

It should be noted that the embodiment using a shift register means SHR and a select/write means SM/WM is only one embodiment of the invention in order to select the data bits from the input data bit sequence BS which are supposed to form a respective code symbol in each memory location of the interleaving memory. Other embodiments are also possible, as long as the selection of the appropriate data bits for the formation of the respective code symbols is guaranteed according to equation (1).

Independent of the number N of data bits forming the code symbol and independent of the interleaving depth $N_W$ one possibility of the selection of the data bits is of course to use a single shift register of length M, whereafter the select/write means SM/WM will run through the complete data bit sequence of M bits and will perform the respective selection of the data bits. However, this may not be a very feasible solution, since the number of data bits M per bit sequence may be very large.

However, for the sequential formation of the code symbols it is not necessary to have available the complete data bit sequence of M bits in a shift register, but it is only necessary to have available in a shift register respectively at each clock timing the two (or N) bits that will form the respective code symbols. As is seen in Fig. 6a, 6b and as is also indicated with the above equation (1), it is sufficient to have available simultaneously in a shift register means SHR the respective data bits of bit positions m (n=1), m (n=2)...m (n=N) which respectively form a code symbol. Therefore, the length of the shift register in the shift register means SHR only need to be $N*N_W$ or it is possible to provide N registers each having a length of $N_W$. Stepping through the memory locations by changing the row index (the writing of code symbols is performed in the row direction), of course a shift means SHFT is necessary in order to sequentially shift the registers in order to have available in the shift register the data bits to be stored in the new memory location, whilst during the shifting of the shift register already new bits can be read in from the input data bit sequence.

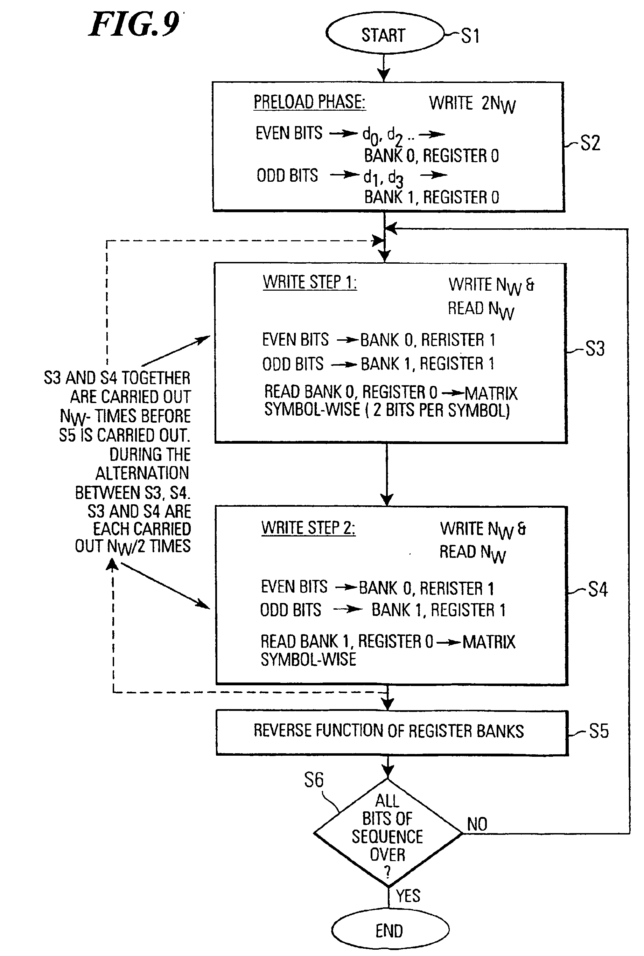

As will be explained below, with a more concrete example for N=2 in Fig. 8a, Fig. 9, it is possible to always read data bits from a first register at particular register positions and then switch to the reading from another register in the next step, wherein the next step here means that the next memory location in the row direction is written with a code symbol selected from the respective registers.

If for example the even index input bits are stored in a first register and the odd index bits are stored in a second register, then a code symbol reading can be carried out alternately between the first and second register if $N_W$ is an even number. Namely, as is seen in Fig. 6a, 6b, independent of the selected number N, a present code symbol, e.g. $d_0, d_4, d_8$, is always formed of bits at even bit positions whereas the code symbol for the next (row-wise) memory location is formed by $d_1, d_5, d_9$, i.e. bits at odd bit positions. Therefore, in Fig. 6a two bits are respectively read alternately from the first and second register. It is interesting to note that this alternate reading from the registers is independent of N, however, it is not independent of $N_W$.

As is shown in Fig. 6c, for $N_W=7$, i.e. for an odd $N_W$, each code symbol of the respective data word is formed by a combination of a data bit at an even position and a data bit at an odd position (e.g. $d_0, d_7$ or $d_{15}, d_{22}$). This is also generally true for any N, as is indicated with the dashed line in Fig. 6c. However, the above-mentioned equation (1) generally also holds for this case, since it indicates the exact bit positions to be read from the input data bit sequence.

Also in the above case for an odd $N_W$, i.e. an odd interleaving depth, only one register of length $N*N_W$ or N registers of length $N_W$ will be sufficient, only that now bits will have to be read from specific bit positions from several registers simultaneously. As will be appreciated from Fig. 6a, 6b, as long as $N_W$ is an even number, the odd bits can always be read for each code symbol independent of N from one register and the even bits from the other register. In Fig. 6c, for the general case of $N_W$ being odd, it is possible to derive relationships as to which bit positions should be alternately read from all the shift registers for each N as will be explained below with reference to Fig. 8b and Fig. 6c.

## SECOND EMBODIMENT (N=2 AND R=1/2)

Hereinafter, with reference to Fig. 8a, Fig. 9 an embodiment is described for forming code symbols from two data bits, i.e. N=2 for an arbitrary (even) $N_W$. It should be noted that this embodiment advantageously uses parallely output data bits from a convolutional encoder operating with a coding rate of r=1/2, however, it is also possible that the data bits arrive serially, in which case different timing relationships must be considered. However, the embodiment with several shift registers as shown in Fig. 8a and described hereinafter is not restricted to a combination with a particular convolutional encoder of r=1/2, since the number of (parallely) output data bits from the convolutional encoder is not directly linked to the number of data bits forming one code symbol. That is, the channel encoder performs a special channel encoding outputting a predetermined number of bits, whilst the modulation scheme (QPSK, 16QAM etc.) in the modulator determines how many data bits form one code symbol.

As is seen in Fig. 8a, the embodiment of the shift register means SHR comprises two shift register banks $b_0$, $b_1$ each consisting of a first register $b_0r_0$, $b_1r_0$ and a second shift register $b_0r_1$, $b_1r_1$. The length of each shift register corresponds to the interleaving depth $N_W$. The switch means SW1, SW2 output the data bits directly into the respective memory location in the interleaving matrix IM which is addressed by the write means WM. That is, the shift registers are located before the bit interleaving matrix IM (e.g. a RAM) used for interleaving.

As is seen in the section "after preload" (the preloading will be described with more detail below) the first register of the first bank $b_0r_0$ stores $N_W$ data bits of even bit positions in the input data bit sequence. Similarly, the first register of the second bank $b_1r_0$ stores data bits from the odd bit positions of the input data bit sequence, respectively indicated with $d_0$, $d_2$,..., $d_{2N_W-2}$ and $d_1$, $d_3$,...,$d_{2N_W-1}$) in Fig. 8a. As stated above, various possibilities can be used in order to have the odd and even bits present in the first and second respective register. In a preferred embodiment, it is easy to clock in the respective odd and even data bits into the two registers, if the convolutional encoder outputs two bits parallely for a r=1/2 encoding. Such bits then arrive on the two data lines coming from the convolutional encoder as is schematically shown in Fig. 8a (data 0, data 1).

The provision of the registers (having length $N_W$ and having bit positions numbered 0, 1..., $N_W$ beginning with the least significant bit position 0 at the far right) will allow to form the code symbols for all memory locations of one row, as may be taken from Fig. 6a. As can be seen from the "write step 1", each code symbol in Fig. 8a (for even $N_W$ consists alternately of two data bits selected from two specific bit positions in one respective register. In Fig. 8b (for odd $N_W$) each code symbol consists of two data bits selected for two respective bit positions in two separate registers as explained below in more detail.

That is, the select means SM respectively reads the least significant bit $d_0$ at the least significant bit position 0 at the far right end in Fig. 8a (which was the first bit loaded during the preload phase) and the bit $\mathbf{d}_{N_W}$ at the bit position $N_W/2$ (if the bit positions are numbered from 0 to $N_W-1$ as described above) which are output as code symbol to memory location $IM_{00}$. For the example in Fig. 6a, this would be the code symbol (0,4).

Then, the switch means SW1, SW2 switches to the first register of the second register bank $b_1,r_0$ containing the bits of the odd bit positions. Thus, the code symbol $d_1$, $d_{N_W+1}$ is read from the least significant bit position 0 at the far right end in the register and the bit position $N_W/2$ in the shift register $b_1r_0$. For the example in Fig. 6a, this would be the code symbol 1,5.

As is also indicated in "write step 1", after each reading the shift means SHFT shifts the register which was read in the last write cycle. That is, when a bit pair is read from the first register of the second bank, the first register of the first bank is shifted one bit. Thus, the first register of the first bank is prepared to allow the reading out of the next code symbol for the next memory position from the same bit positions as before. Simultaneously, as is indicated in the "write step 1" the data bits of the next $2N_W$ bit positions are read into the second registers of the first and second bank, where again the second register of the first bank stores the even bits and the second register of the second bank stores the odd bits.

That is, while one register in a bank is loaded with bits, two bits of the other one are read out to the interleaving matrix IM. The two registers of each bank change their function alternately after $N_W$ clock periods. It is seen from Fig. 5, that the writing of one memory location in the matrix requires the provision of pairs of data bits, e.g. $d_0$, $d_{N_W}$....The provision of four registers as in Fig. 8a enables a prestoring of the bits as well as a grouping of bits and selecting of bits pair-wise, whilst still only $N_W$ clock periods are necessary for forming the respective pairs of one row. Thus, the write time becomes the same as the read time since in every period ($N_W$ cycles) $2*N_W$ bits can be stored to the interleaving matrix.

As is shown in Fig. 8a an additional "preload" time is needed by a preload means PLD for loading the shift registers SHR for the first time. As will be appreciated, since one row (e.g. row 0) in Fig. 5 has to store a total of $2N_W$ bits, the shift register SHR has to have a length of $2*N_W$ if data arrives from the convolutional encoder in a serial form. Due to the fact that the data arrives serially at the interleaver ③ in Fig. 2, i.e. serially at the shift register SHR in Fig. 7, $2N_W$ clock periods are needed in addition to the write accesses in principle.

However, in a convolutional encoder of rate, e.g. r=1/2 two bits $d_0$, $d_1$ are generated in a parallel form and the two bits could arrive at the same time. If the bits thus arrive in parallel, a reduction of the preload time needed by the preload means PLD for loading the shift registers $r_0$ with the odd and even bits can be achieved, when the two registers with length $N_W$ are loaded during the "preload" time of now only $N_W$ clock periods. Therefore, the combination of a convolutional encoder of r=1/2 with code symbols of N=2 is a very advantageous embodiment. Then the clocking in of data bits in pairs of two can be performed at the same clock rate as the reading out of the respective two bits from the respective shift registers. That is, during the clocking in of $2N_W$ bits, exactly $2N_W$ bits for code symbols of memory locations in one row are read out from the respective other registers.

Therefore, whilst in general the idea of the invention is directed to the symbol-wise storage of two bits together in one location of the interleaving matrix, it is particularly advantageous if the QPSK modulation method together with a convolutional encoder of rate 1/2 and two parallel shift register banks is used. However, as explained above, the invention can also be generally applied with a singleregister of length $2*N_W$, only that here the "preload time" is twice as long.

## THIRD EMBODIMENT (INTERLEAVING METHOD FOR N=2, EVEN $N_W$)

Whilst the specific usage of the register banks is shown generally in Fig. 8a, where data bits from a convolutional encoder with r=1/2 are stored in four registers and where the data selection is done parallely, Fig. 9 shows a flow chart of the operation for the interleaving method of N=2 in Fig. 8a.

In step S2, the so-called "preload phase", in total $2N_W$ bits are stored in registers 0 of bank 0 and bank 1. As is seen in Fig. 8a, the even bits $d_0$, $d_2$...$d_{N_W-2}$, $d_{N_W}$,... $d_{2N_W-2}$, are stored in $b_0r_0$ (bank 0, register 0) and the odd bits $d_1$, $d_3$...$d_{N_W-1}$, $d_{N_W+1}$,... $d_{2N_W-1}$, are stored in $b_1r_0$ (bank 1, register 0). Thus, a length of $N_W$ for each register is completely sufficient. After completing step S2, in total the bits $d_0$ to $d_{2N_W-1}$ are stored in registers.

In step S3 the bits stored in the two registers in step S2 must be combined to be written to a first memory location 0 in the interleaving matrix. Therefore, in step S3 one symbol is read from those registers. Essentially, in Fig. 8a the gray-shaded rows in the "preload phase" correspond to the symbols stored in row 0 in Fig. 5 if the switches SW1, SW2 respectively select odd and even bits from the respective register. Simultanously with the reading of bits from bank 0, register 0 and bank 1, register 0, the registers 1 of banks 0 and bank 1 are filled with a number of $2N_W$ bits intended for the next row 1 in the matrix in Fig. 5. The next $2N_W$ data bits are denoted $d_{2N_W}$ to $d_{4N_W-1}$.

The operation of the switch means SW1, SW2 is such that the correct pairs of bits are selected. While reading the registers a symbol is therefore built by taking two bits of one register. For the first symbol, the bits $d_0$ and $\mathbf{d}_{N_W}$ of register 0 in bank 0 are taken. Whilst in the position of the switches SW1, SW2 in Fig. 8a the data $d_0$, $\mathbf{d}_{N_W}$ have been read out from two particular bit positions of register 0 in bank 0, the switches are then set to read one symbol, i.e. 2 bits $d_1$, $d_{N_W+1}$ from the register 0 of bank 1 at exactly the same bit positions in write step 2. Whenever a pair of bits has been read from a register, the contents of the register is shifted one bit to the right (as can be seen from the blank bit position in register 0, bank 0 in "write step 1" in Fig. 8a)

If in step S3/S4 the switches SW1, SW2 have respectively been switched to read a pair from bank 0/1 the corresponding register is shifted one bit to the right.

As is indicated with the square boxes at the arrows denoted data i, data q, in Fig. 8a these square boxes always indicate the last read pair of bits (one symbol) from the respective register. The alternate reading (and shifting) of a pair of bits respectively from bank 0, register 0 and bank 1, register 0 in the write step 1 and the write step 2 is performed in total exactly $N_W$ times for setting one row of data symbols until the process changes to the alternate reading (again $N_W$-times) from bank 0, register 1 and bank 1, register 1 into which the next data bits have been written during the alternate reading process from bank 0, register 0 and bank 1, register 0.

Thus, while reading the register a symbol is built by taking two bits of one single register. For the first symbol, the bits $d_0$ and $d_{N_W}$ of register 0 in bank 0 are taken. The position for read out is kept, but in the second reading the register 0 of bank 1 is used and data bits $d_1$, $d_{N_W+1}$ are read. Then the register contents is shifted to the right.

Therefore, once the preload step S2 is finished, the registers are shifted every second clock period (during the whole read period) while the output lines for the I and Q bits switch from one to the other bank with every clock period. Thus, the outgoing I bit and the Q bit will be stored as symbol together to the same memory address of the interleaver matrix IM.

As is indicated in step S5, obviously, after having read $2N_W$ data bits and stored these as data symbols in the matrix IM, the function of the registers 0, 1 of each bank is reversed. Namely, as explained above, after $N_W$ clock periods the complete data necessary for storing symbols in the next row need to be read from the register 1, whilst the next data for the row 3 will again be stored in the register 0 of each bank.

Essentially, table 1 shows the sequential reading of code symbols from the registers:

Table 1

|  | Write Step 1 | Write Step 2 | Write Step 1 | Write Step 2 |
|---|---|---|---|---|
| The reading order from SHR is | $(d_0\ d_{N_W})$ | $(d_1\ d_{N_W+1})$ | $(d_2\ d_{N_W+2})$ | $(d_3\ d_{N_W+3})$ |
|  | reg ø bank ø | reg ø bank 1 | reg ø bank ø | reg ø bank 1 |

The process described in Fig. 8a, 9 allows to fill the interleaving matrix exactly in $N_W*N_R/2$ access steps, namely in exactly the same time that is necessary for reading out the interleaving matrix, with additional $N_W$ cycles for preloading the shift registers. Thus, the complete interleaving and forming of code symbols can be done in less time with less memory requirements.

## FOURTH EMBODIMENT (INTERLEAVING METHOD FOR N=2, ODD $N_W$)

As explained above, even when $N_W$ is an odd number, the above described method can be applied. But then, in step S5, the positions for reading I and Q bits have to be changed after $N_W$ clock periods. This is explained with reference to Fig. 8b below.

Fig. 8b shows in step ① the situation in the "after preload" as in Fig. 8a for the case of N=2 and an odd $N_W$=7, 14 (=$2N_W$) bits are stored in the registers $b_0r_0$ and $b_1r_0$ and two bits 14, 15 will be written into the registers $b_0r_1$ and $b_1r_1$, respectively, when bits 0, 7 are read out in the first reading out process of "write step 1".

In the first $N_W$ ($N_W$=7) steps ①-⑦, code symbols are read out alternately either from the least significant bit position LSB (at the far right end position 0) of the register $b_0r_0$ and from the central position ($N_W$-1)/2 (if the bit positions are numbered from 0 to $N_W$-1 as described above) of the register $b_1r_0$ or from the central position of the register $b_0r_0$ and the least significant bit position LSB (at the far right end) of the register $b_1r_0$ whilst the respective even and odd bits are successively read into the registers $b_0r_1$, $b_1r_1$, which are fully filled after step ⑦.

For the next cycle of steps beginning with step ⑧, the alternate reading starts again, now reading alternately the least significant position LSB in the register $b_0r_1$ and the central position in register $b_1r_1$ and vice versa.

Thus, the procedure for odd $N_W$ is essantially the same as the one for even $N_W$, only that in the "write step 1" in Fig. 9, the reading is performed from two different banks b0r0 & b1r0 and "in the write step 2" in Fig. 9 the reading is also performed from two different banks b0r0 & b1r0. In total, step S3 and step S4 together are carried out $N_W$ (=7) times, before the registers are switched in step S5.

Essentially, table 2 shows the sequential reading of code symbols from the registers for odd $N_W$ which is essentially the same as the one for even $N_W$, only that two different registers are used for reading each code symbol pair:

Table 2

| | Write Step 1 | Write Step 2 | Write Step 1 | Write Step 2 |
|---|---|---|---|---|
| The reading order from SHR is | $d_0$ from $b_0r_0$ $d_{N_W}$ from $b_1r_0$ | $d_1$ from $b_1r_0$ $d_{N_W+1}$ from $b_0r_0$ | $d_2$ from $b_0r_0$ $d_{N_W+2}$ from $b_1r_0$ | $d_3$ from $b_1r_0$ $d_{N_W+3}$ from $b_0r_0$ |
| | reg ø bank ø and reg ø bank 1 | reg ø bank ø and reg ø bank 1 | reg ø bank ø and reg ø bank 1 | reg ø bank ø and reg ø bank 1 |

The result of a reading and writing process for $N_W$=7 is shown in Fig. 6c.

**INDUSTRIAL APPLICABILITY**

As explained above, the principle of the invention is based on the symbol-wise storage of data bits in each memory location of a memory, wherein each memory location can store more than one bit as is the usual case in a RAM. The invention is independent of the selection process used for assigning the specific bits of the input data bit sequence to the respective memory location. The invention is also independent of the specific digital modulation scheme used by the modulator, i.e. any number of data bits can be combined to form a code symbol if the selection means is adapted to select the respective bits from the input data bit sequence. Furthermore, the invention is also independent of the specific encoder used at the input side of the interleaving memory. However, a preferred embodiment of the invention is the usage of a convolutional coder outputting N bits parallely and the usage of N parallel shift registers together with the formation of a code symbol containing N bits, since then the write in time will be the same as the read out time in the interleaving memory.

The invention is not restricted to a CDMA system or a frame-wise communication system. However, advantageously each input data bit sequence corresponds to one data frame in a frame-wise transmission method. It can also be arranged that each row in the interleaving matrix stores one data frame of a plurality of user channels.

The above described invention is not restricted to the teachings disclosed therein. That is, the skilled person can perform a various modifications and variations of the invention without being restricted to the above described teachings, which are presently perceived as the best mode of the invention. Furthermore, the invention is not restricted to the above description and the claims and the invention may comprise further embodiments resulting from individual combinations of separately described features or separately claimed features in the claims. Therefore, the scope of the invention is entirely defined by the appended claims.

Reference numerals in these claims only serve clarification purposes and do not limit the scope of the invention.

**Claims**

1.    An interleaver (IL) for interleaving an input data bit sequence (BS) of M data bits, including an interleaving memory (IM) having a number of memory locations (IM00, IM01...) for storing said M data bits of said input data bit sequence, wherein each memory location (IM00, IM01) stores a respective code symbol consisting of a predetermined number N of data bits selected from said input data bit sequence (BS), wherein the number of data bits N per each code symbol is the same, but each code symbol consists of different data bits respectively selected from the input data bit sequence.

2. An interleaver (IL) according to claim 1,
   *characterized in that*
   said input data bit sequence (BS) of M data bits consists of data bit sets ($c_0$, $c_1$) each including a predetermined number (1/r) of bits resulting from a convolutional encoding of a respective data bit using a predetermined coding rate (e.g. r=1/2) in a convolutional encoder.

3. An interleaver (IL) according to claim 1,
   *characterized in that*
   said interleaving memory (IM) has $N_W$ x $N_R$/N memory locations (IM00, IM01...) for storing said M data bits of said input data bit sequence, wherein $N_W$ denotes the number of columns corresponding to the interleaving depth, N denotes the predetermined number of data bits forming one code symbol and $N_R$/N denotes the number of rows in said interleaving memory.

4. An interleaver (IL) according to claim 3,
   *characterized by*
   a write/read (W/R) means for writing said M data bits into said memory locations (IM00, IM01) in the row direction such that each memory location (IM00, IM01) stores said number N of selected data bits forming one code symbol (e.g. I, Q) and for reading out said code symbols from said memory locations (IM00, IM01) in the column direction to provide an interleaved output data bit sequence of said stored code symbols.

5. An interleaver (IL) according to claim 4,
   *characterized in that*
   a modulator (MOD) using a predetermined digital modulation scheme (QPSK, 16QAM) is connected to an output of said interleaver providing said interleaved output data bit sequence of said code symbols, wherein said predetermined number (N) of data bits forming one respective code symbol is determined by the digital modulation scheme (QPSK, 16QAM) used by the modulator (MOD).

6. An interleaver (IL) according to claim 1,
   *characterized in that*
   wherein each code symbol is formed by N respective data bits respectively selected from the [$m=n_W+(n-1)$ $*N_W+n_R*N_W*N$]-th positions of the input data bit sequence, where n = 1, 2...N denotes the n-th data bit of the code symbol, $n_W$ = 0, 1,...$N_W$-1 denotes the column address of the memory location (IM00, IM01) of the code symbol and $n_R$ = 0, 1,...($N_R$/N)-1 denotes the row address of the memory location (IM00, IM01) of the code symbol.

7. An interleaver (IL) according to claim 4,
   *characterized in that*
   said input data bit sequence has a length of M = $N_W$ x $N_R$ bits and said write/read means (W/R) writes/ reads said data bits to/from said interleaving memory in $N_W$ x $N_R$/N write/read cycles.

8. An interleaver (IL) according to claim 4,
   *characterized in that*
   for N=2 data bits per code symbol and even $N_W$ said write/read means (W/R) comprises:

   - two shift register banks (b0, b1) each consisting of a first and a second shift register (r0, r1) of length $N_W$, wherein the even and odd numbered data bits of said input data bit sequence are respectively stored in said first register (r0, r1) of said first and second shift register bank;

   - select/write means (SM/RW) for selecting at each write cycle 2 data bits of the least significant bit position and the $N_W$/2 position from the first register (r0, r1) alternately from the first and second register bank and for writing said 2 selected bits as one code symbol to a respective memory position in said interleaving memory;

   - shift means (SHFT) for shifting the register (r0, r1) which was read at the last write cycle and the second registers of the register banks (b0, b1) while reading in the next odd and even bits of a next input data bit sequence to the respective second register (r0, r1) of each register bank; and

- wherein after $N_W$ alternate data bit selecting and shifting cycles the function of the registers within each bank is reversed.

**9.** An interleaver (IL) according to claim 4,
***characterized in that***
for N=2 data bits per code symbol and odd $N_W$ said write/read means (W/R) comprises:

- two shift register banks (b0, b1) each consisting of a first and a second shift register (r0, r1) of length $N_W$, wherein the even and odd numbered data bits of said input data bit sequence are respectively stored in said first register (r0, r1) of said first and second shift register bank;

- select/write means (SM/RW) for selecting at each write cycle 2 data bits alternately either from the least significant bit position (LSB) of the first register of the first bank ($b_0r_0$) and from the central position (($N_W$-1)/2) of the first register of the second bank $b_1r_0$ or from the central position of the first register of the first bank $b_0r_0$ and the least significant bit position (LSB) of the first register of the second bank ($b_1r_0$) and from the central position of the register $b_1r_0$, and for writing said 2 selected bits as one code symbol to a respective memory position in said interleaving memory;

- shift means (SHFT) for shifting the two registers (r0, r0) which were read at the last write cycle and the registers of the register banks (b0, b1) which were not read, while reading in the next odd and even bits of a next input data bit sequence to the respective second register (r0, r1) of each register bank; and

- wherein after $N_W$ alternate data bit selecting and shifting cycles the function of the registers within each bank is reversed.

**10.** An interleaver (IL) according to claim 8 or 9,
***characterized in that***
said write/read means (W/R) comprises preload means (PLD) for preloading the first registers of said first and second shift register banks (b0, b1) respectively with data bits of said input data bit sequence such that the even numbered data bits are stored in said first register (r0, r1) of said first shift register bank and the odd numbered data bits are stored in said first register (r0, r1) of said second shift register bank before the alternate selecting and reading is started.

**11.** An interleaver (IL) according to claim 8 or 9,
***characterized in that***
said write/read means (W/R) comprises read means (RD) for reading the code symbols sequentially in the column direction from the interleaving memory to provide said interleaved output data bit sequence consisting of said stored code symbols.

**12.** An interleaver (SHR, IM) for a modulator of a transmitter, which uses a predetermined digital modulation scheme (QPSK, QAM) where a number N of data bits are modulated as one code symbol, for interleaving an input data bit sequence (BS) of M data bits, comprising:

a) an interleaving memory (IM) having $N_W$ x $N_R$/N memory locations (IM00, IM01) for storing said M data bits of said input data bit sequence, where $N_W$ denotes the number of columns corresponding to the interleaving depth and $N_R$/N denotes the number of rows in said interleaving memory;

b) a write/read (W/R) means

- for writing said M data bits into said memory locations (IM00, IM01) in the row direction such that each memory location (IM00, IM01) stores simultaneously a number N of data bits forming one code symbol (e.g. I, Q) according to the predetermined modulation scheme (QPSK, 16QAM); and

- for reading out said code symbols from said memory locations (IM00, IM01) in the column direction to provide an interleaved output data bit sequence of said stored code symbols; and

- wherein each code symbol is formed by N respective data bits respectively selected from the [$m=n_W+(n-1)*N_W+n_R*N_W*N$]-th positions of the input data bit sequence, where n = 1, 2...N denotes the n-th data bit of the code symbol, $n_W = 0, 1,...N_W-1$ denotes the column address of the memory location (IM00, IM01) of the code symbol and $n_R = 0, 1,...(N_R/N)-1$ denotes the row address of the memory location (IM00, IM01) of the code symbol.

**13.** An interleaver (IL) according to claim 12,
*characterized in that*
said input data bit sequence (BS) of M data bits consists of data bit sets ($c_0$, $c_1$) each including a predetermined number ($1/r$) of bits resulting from a convolutional encoding of a respective data bit using a predetermined coding rate (e.g. $r=1/2$) in a convolutional encoder.

**14.** An interleaver (IL) according to one or more of the above claims 1-13, *characterized in that*
said input data bit sequence corresponds to the data of one frame of a time multiplex communication system.

**15.** An interleaver (IL) according to claim 14,
*characterized in that*
said communication system operates according to a CDMA technique.

**16.** A transmitter comprising an encoder (ENC), an interleaver (IL) according to one or more of claims 1-15 and a modulator, said encoder providing an encoded ($r=1/2$) input data bit sequence to said interleaver, said interleaver (IL) providing an interleaved output data bit sequence of said code symbols to said modulator (MOD) and said modulator modulating said code symbols according to a predetermined modulation scheme.

**17.** A method for interleaving an input data bit sequence (BS) of M data bits using an interleaving memory (IM) having a number of memory locations (IM00, IM01) for storing said M data bits, comprising the following steps:

- selecting from said input data bit sequence simultaneously a predetermined number (N) of data bits to form a respective code symbol;

- writing the data bits of a respective code symbol to a respective memory location (IM00, IM01) in said interleaving memory; and

- wherein the number of data bits (N) per each code symbol is the same, but each code symbol consists of different data bits respectively selected from the input data bit sequence.

**18.** A method according to claim 17,
*characterized in that*
said interleaving memory (IM) has $N_W$ x $N_R/N$ memory locations (IM00, IM01) for storing said M data bits of said input data bit sequence, wherein $N_W$ denotes the number of columns corresponding to the interleaving depth, N denotes the predetermined number of data bits forming one code symbol and $N_R/N$ denotes the number of rows in said interleaving memory.

**19.** A method according to claim 18,
*characterized by the following steps:*
writing said M data bits into said memory locations (IM00, IM01) in the row direction such that each memory location (IM00, IM01) stores said number N of data bits forming one code symbol (e.g. I, Q) and reading out said code symbols from said memory locations (IM00, IM01) in the column direction to provide an interleaved output data bit sequence of said stored code symbols.

**20.** A method according to claim 19,
*characterized in that*
a modulator (MOD) using a predetermined digital modulation scheme (QPSK, 16QAM) is connected to an output of said interleaver providing said interleaved output data bit sequence of said code symbols, wherein said predetermined number (N) of data bits forming one respective code symbol is determined by the digital modulation scheme (QPSK, 16QAM) used by the modulator (MOD).

**21.** A method according to claim 17,
*characterized in that*
selecting, as code symbol, N respective data bits respectively from the [$m=n_W+(n-1)*N_W+n_R*N_W*N$]-th positions of the input data bit sequence, where n = 1, 2...N denotes the n-th data bit of the code symbol, $n_W$ = 0, 1,...$N_W$-1 denotes the column address of the memory location (IM00, IM01) of the code symbol and $n_R$ = 0, 1,...($N_R$/N)-1 denotes the row address of the memory location (IM00, IM01) of the code symbol.

**22.** A method according to claim 19,
**characterized in that**
said input data bit sequence has a length of M = $N_W$ x $N_R$ bits, wherein said data bits are written/read from said interleaving memory in $N_W$ x $N_R$/N write/read cycles.

**23.** A method according to claim 19,
**characterized in that**
for N=2 data bits per code symbol and even $N_W$, said writing/reading steps comprises the following steps:

- storing (S2) even and odd numbered data bits of said input data bit sequence respectively in a first register (r0) of a first and second shift register bank (b0, b1);

- selecting (S3, S4) at each write cycle 2 data bits from the least significant bit position and the $N_W$/2-th position from the first register (r0, r1) alternately of the first and second register bank and writing said 2 selected bits as one code symbol to a respective memory position;

- shifting (S3, S4) the register (r0, r1) which was read at the last write cycle and the second registers of the register banks (b0, b1) while reading in the next odd and even bits of a next input data bit sequence to the respective second register (r1) of each register bank; and

- wherein after $N_W$ alternate data bit selecting and shifting cycles the function of the registers is reversed (S5).

**24.** A method according to claim 19,
**characterized in that**
for N=2 data bits per code symbol and odd $N_W$, said writing/reading steps comprises the following steps:

- storing (S2) even and odd numbered data bits of said input data bit sequence respectively in a first register (r0) of a first and second shift register bank (b0, b1);

- selecting (S3, S4) at each write cycle 2 data bits alternately either from the least significant bit position (LSB) of the first register of the first bank ($b_0r_0$) and from the central position (($N_W$-1)/2) of the first register of the second bank ($b_1r_0$) or from the central position of the first register of the first bank ($b_0r_0$) and the least significant bit position (LSB) of the first register of the second bank ($b_1r_0$) and from the central position of the register ($b_1r_0$), and for writing said 2 selected bits as one code symbol to a respective memory position;

- shifting (S3, S4) the two registers (r0, r0) which were read at the last write cycle and the registers of the register banks (b0, b1) which were not read, while reading in the next odd and even bits of a next input data bit sequence to the respective second register (r0, r1) of each register bank; and

- wherein after $N_W$ alternate data bit selecting and shifting cycles the function of the registers within each bank is reversed.

**25.** A method according to claim 22 or 23,
**characterized by**
a preloading step for preloading the first registers (r0) of said first and second shift register banks (b0, b1) respectively with data bits of said input data bit sequence such that the even numbered data bits are stored in said first register (r0) of said first shift register bank (b0) and the odd numbered data bits are stored in said first register (r0) of said second shift register bank (r1) before the alternate selecting and reading is started.

**26.** A method according to claim 22 or 23,
**characterized by**
a step for reading the code symbols sequentially in the column direction from the interleaving memory to provide said interleaved output data bit sequence consisting of said stored code symbols.

**27.** A method for interleaving an input data bit sequence (BS) of M data bits to output an interleaved output data bit sequence to a modulator of a transmitter, which uses a predetermined digital modulation scheme (QPSK, QAM) where a number N of data bits are modulated as one code symbol, using an interleaving memory (IM) having $N_W$ x $N_R$/N memory locations (IM00, IM01) for storing said M data bits, where $N_W$ denotes the number of columns corresponding to the interleaving depth and $N_R$/N denotes the number of rows in said interleaving memory, comprising the following steps:

- selecting from said input data bit sequence a predetermined number (N) of data bits to form a respective code symbol;

- writing said M data bits into said memory locations (IM00, IM01) in the row direction such that each memory location (IM00, IM01) stores simultaneously said selected number N of data bits forming one code symbol (I and Q for QPSK) according to the predetermined modulation scheme (QPSK, 16QAM);

- reading out said code symbols from said memory locations (IM00, IM01) in the column direction to provide an interleaved output data bit sequence of said stored code symbols; wherein

- each code symbol is formed by selecting N respective data bits respectively from the $[m=n_W+(n-1)$ $*N_W+n_R*N_W*N]$-th positions of the input data bit sequence, where n = 1, 2...N denotes the n-th data bit of the code symbol, $n_W$ = 0, 1,...$N_W$-1 denotes the column address of the memory location (IM00, IM01) of the code symbol and $n_R$ = 0, 1,...($N_R$/N)-1 denotes the row address of the memory location (IM00, IM01) of the code symbol.

# FIG.1

USER DATA DOWNLINK

USER DATA UPLINK

TO/FROM RNC

HF SECTION

RX FILTER

LNA

ANT

DUPLEX FILTER

MCPA

TRX-RF

BASEBAND TRANSMITTER Tx

ET

ATM-IFX/IFC

USER DATA US

ENC

BBTX

MODULATED DATA

TRX-DIG

ATM SWITCH

BASEBAND RECEIVER Rx

ATM-IFX/IFC

DEC

① USER DATA US

BBRX

BBIF

ALT

MMX

BBRA

BTS

EP 1 089 440 A1

**FIG.2**

FPGA TPC-ACK

CI

DSP ①

FPGA TPC-ULI

DPRAM CCCH

FPGA CCOD-CCCH

FPGA FEED-THROUGH

CONTROL INFORMATION FOR USER CHANNELS

FROM ATM-SWITCH

FPGA ATM-IN ②

FPGA CH-BUILD-0

FPGA CCOD-TCH

FPGA INTER-MOD ③

FPGA BBTX-OUT ⑤

TO BBTX BOARDs

RAM FRAME BUFFER 1

RAM FRAME BUFFER 2

| US1 | US2 | US3 | ··· | → t

ONE PACKET FOR EACH USER IN A FRAME OF 10ms

FPGA RAM-IF1

FPGA RAM-IF2

④ RAM INTER-LEAV. 1

RAM INTER-LEAV. 2

RAM INTER-LEAV. 3

RAM INTER-LEAV. 4

RAM INTER-LEAV. 5

RAM INTER-LEAV. 6

ENC FUNCTIONAL OVERVIEW

EP 1 089 440 A1

# FIG.3
PRIOR ART

EP 1 089 440 A1

## FIG.4
### PRIOR ART

WRITE IN

$N_W-1$

$d_0$  $d_1$ ⋯ $d_{N_W-1}$

$IM_{00}$  $IM_{01}$

$d_{N_W}$ ⋯ $d_{2N_W-1}$

$0$

READ OUT

$N_R-1$

IM

BITWISE

## FIG.5
### PRINCIPLE OF THE INVENTION (FOR N = 2)

WRITE IN

$N_W-1$

$d_0$  $d_1$ ⋯ $d_{N_W-1}$

$IM_{00}$  $IM_{01}$

$d_{N_W}$ ⋯ $d_{2N_W-1}$

$0$

READ OUT

$N_R/2-1$

IM

SYMBOLWISE

$$n_W + (n_R + n-1)N_W + n_R N_W (N-1) = m$$

**FIG.6a**

$N = 2(\text{QPSK})$

$N_W = 4$

| $n_W$ | 0 | 1 | 2 | 3 | |
|---|---|---|---|---|---|
| $n_R = 0$ | 0 | 1 | 2 | 3 | $n = 1$ |
| | 4 | 5 | 6 | ⑦ | $n = 2$ |
| $n_R = 1$ | 8 | 9 | 10 | 11 | $n = 1$ |
| | 12 | 13 | 14 | 15 | $n = 2$ |
| $n_R = 2$ | 16 | 17 | 18 | 19 | $n = 1$ |
| | 20 | 21 | 22 | 23 | $n = 2$ |
| $n_R = 3$ | 24 | 25 | 26 | 27 | $n = 1$ |
| | 28 | 29 | 30 | 31 | $n = 2$ |
| $n_R = 4$ | 32 | 33 | 34 | 35 | $n = 1$ |
| | 36 | 37 | 38 | 39 | $n = 2$ |
| | 40 | 41 | 42 | 43 | |

BIT POSITION m
IN INPUT DATA
BIT SEQUENCE

**FIG.6b**

$N = 4 \text{ (e.g.16QAM)}$

$N_W = 4$

| $n_W$ | 0 | 1 | 2 | 3 | |
|---|---|---|---|---|---|
| $n_R = 0$ | 0 | 1 | 2 | 3 | $n = 1$ |
| | 4 | 5 | 6 | 7 | $n = 2$ |
| | 8 | 9 | 10 | 11 | $n = 3$ |
| | 12 | 13 | 14 | 15 | $n = 4$ |
| $n_R = 1$ | 16 | 17 | 18 | 19 | $n = 1$ |
| | 20 | 21 | 22 | 23 | $n = 2$ |
| | 24 | 25 | 26 | 27 | $n = 3$ |
| | 28 | 29 | 30 | 31 | $n = 4$ |
| $n_R = 2$ | 32 | 33 | 34 | 35 | $n = 1$ |
| | 36 | 37 | 38 | 39 | $n = 2$ |
| | 40 | 41 | 42 | 43 | $n = 3$ |

# FIG.6c

$$N = 2 \; ; \; N_W = 7$$

| $n_W$ | 0 | 1 | 2 | 3 | 4 | 5 | 6 |
|---|---|---|---|---|---|---|---|
| $n_R = 0$ | 0 | 1 | 2 | 3 | 4 | 5 | 6 |
| | 7 | 8 | 9 | 10 | 11 | 12 | 13 |
| $n_R = 1$ | 14 | 15 | 16 | 17 | 18 | 19 | 20 |
| | 21 | 22 | 23 | 24 | 25 | 26 | 27 |

# FIG.7

SELECT MEANS — SM

WRITE MEANS — WM

PRELOAD MEANS — PLD

SHFT

SHIFT REGISTER — SHR

INTERLEAVING MATRIX (SYMBOL-WISE) — IM

READ MEANS — RD

W/R

USER DATA

BS

FRAME IT
R=1/2
CONVOLUTIONAL
CODER

BBTX
(CDMA
MODU-
LATION
UNIT)

- EITHER ONE REGISTER OF LENGTH $2*N_W$ OR
TWO REGISTERS OF LENGTH $N_W$ (FOR QPSK MODULATION)

EP 1 089 440 A1

*FIG.8a*

AFTER PRELOAD

$b_0 r_0$   BANK 0 REGISTER 0        r = 1/2

DATA 0 → | $d_{2Nw-2}$ ..... $d_{Nw}$ $d_{Nw-2}$ ..... $d_2$ $d_0$ | ~LINE 1     ....$d_3 d_2 d_1 d_0$
         BANK 0 REGISTER 1                                      SERIAL DATA        } BANK 0
$b_0 r_1$                                                        STREAM FROM
         BANK 1 REGISTER 0                                      COVOLUTIONAL
DATA 1 → | $d_{2Nw-1}$ .... $d_{Nw+1}$ $d_{Nw-1}$ ..... $d_3 d_1$ | ~LINE 2     ENCODER      } BANK 1
$b_1 r_0$                                                                       
         BANK 1 REGISTER 1
$b_1 r_1$

TO BIT INTERLEAVING MATRIX

← $N_W$ →

WRITE STEP 1 ─ ─ ─ ─                                              SW1

         BANK 0 REGISTER 0
$b_0 r_0$ | $d_{2Nw-2}$ ..... $d_{Nw+2}$ $d_{Nw}$ ..... $d_2$ |    | $d_0$ |
         BANK 0 REGISTER 1                                         DATA i
DATA 0 → | $d_{2Nw}$ |                                                          } IM$_{00}$
$b_0 r_1$                                                          | $d_{Nw}$ |
                                                                  DATA q
         BANK 1 REGISTER 0                                        SW2
$b_1 r_0$ | $d_{2Nw-1}$ ..... $d_{Nw+1}$ $d_{Nw-1}$ ...$d_3$ $d_1$ |
         BANK 1 REGISTER 1
DATA 1 → | $d_{2Nw+1}$ |
$b_1 r_1$

WRITE STEP 2 ─ ─ ─ ─                                              SW1

         BANK 0 REGISTER 0
$b_0 r_0$ | $d_{2Nw-2}$ ..... $d_{Nw+2}$ $d_{Nw}$ ..... $d_2$ |    | $d_1$ |
         BANK 0 REGISTER 1                                         DATA i
DATA 0 → | $d_{2Nw+2}$ $d_{2Nw}$ |                                              } IM$_{01}$
$b_0 r_1$                                                          | $d_{Nw+1}$ |
                                                                  DATA q
         BANK 1 REGISTER 0                                        SW2
$b_1 r_0$ | $d_{2Nw-1}$ ..... $d_{Nw+3}$ $d_{Nw+1}$ ... $d_3$ |
$b_1 r_1$ BANK 1 REGISTER 1
DATA 1 → | $d_{2Nw+3}$ $d_{2Nw+1}$ |

INTERLEAVING COMBINED WITH QPSK MODULATION

# FIG.8b

## FIG.9

START ──S1

PRELOAD PHASE:          WRITE $2N_W$

EVEN BITS ⟶ $d_0$, $d_2$ .. ⟶
                BANK 0, REGISTER 0
ODD BITS ⟶ $d_1$, $d_3$ ⟶
                BANK 1, REGISTER 0

──S2

S3 AND S4 TOGETHER
ARE CARRIED OUT
$N_W$- TIMES BEFORE
S5 IS CARRIED OUT.
DURING THE
ALTERNATION
BETWEEN S3, S4.
S3 AND S4 ARE
EACH CARRIED
OUT $N_W/2$ TIMES

WRITE STEP 1:          WRITE $N_W$ &
                READ $N_W$

EVEN BITS ⟶ BANK 0, RERISTER 1
ODD BITS ⟶ BANK 1, REGISTER 1
READ BANK 0, REGISTER 0 ⟶ MATRIX
SYMBOL-WISE ( 2 BITS PER SYMBOL)

──S3

WRITE STEP 2:          WRITE $N_W$ &
                READ $N_W$

EVEN BITS ⟶ BANK 0, RERISTER 1
ODD BITS ⟶ BANK 1, REGISTER 1
READ BANK 1, REGISTER 0 ⟶ MATRIX
SYMBOL-WISE

──S4

REVERSE FUNCTION OF REGISTER BANKS ──S5

S6 ── ALL BITS OF SEQUENCE OVER ?    NO

YES

END

**European Patent Office**

# EUROPEAN SEARCH REPORT

Application Number

EP 99 11 9012

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|----------|----------------------------------------------------------------------------|-------------------|-----------------------------------------------|
| Y | US 5 430 767 A (MIN BYONG-MIN) 4 July 1995 (1995-07-04) * the whole document * --- | 1-9, 12-24,27 | H03M13/27 |
| Y | EP 0 608 079 A (MATSUSHITA ELECTRIC IND CO LTD) 27 July 1994 (1994-07-27) * the whole document * ----- | 1-9, 12-24,27 | |
| | | | **TECHNICAL FIELDS SEARCHED** (Int.Cl.7) H03M |

The present search report has been drawn up for all claims

| Place of search | Date of completion of the search | Examiner |
|-----------------|----------------------------------|----------|
| THE HAGUE | 23 March 2000 | Devergranne, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 99 11 9012

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2000

| Patent document cited in search report | | Publication date | Patent family member(s) | | Publication date |
|---|---|---|---|---|---|
| US 5430767 | A | 04-07-1995 | KR<br>JP<br>JP | 139192 B<br>2834645 B<br>7312561 A | 01-07-1998<br>09-12-1998<br>28-11-1995 |
| EP 0608079 | A | 27-07-1994 | JP<br>KR<br>US | 6216882 A<br>9702954 B<br>5535220 A | 05-08-1994<br>13-03-1997<br>09-07-1996 |

EPO FORM P0459

For more details about this annex : see Official Journal of the European Patent Office, No. 12/82